# EUROPEAN PATENT APPLICATION

(11) **EP 4 827 294 A1**
(43) Date of publication of application: **21.10.2026**
(21) Application number: 26738227.3
(22) Date of filing: 09.02.2026
(51) Int. Cl.: H10K 59/35, H10H 29/34

(54) **DISPLAY PANEL AND DISPLAY DEVICE**

(30) Priority: 28.02.2025 CN 202510238504
(71) Applicant: Wuhan Tianma Microelectronics Co., Ltd., Wuhan, Hubei 430205 (CN)
(72) Inventor: QIU, Shaoya, Wuhan, Hubei 430205 (CN)
(74) Representative: Lorenz & Kollegen
(86) International application number: PCT/CN2026/077891
(87) International publication number: WO 2026/179692

(57) **Abstract**

The present application Provides a display panel and a display apparatus related to the technical field of displaying for improving the pixel aperture ratio of the display panel. First unit groups and second unit groups of the display panel are alternately arranged in a first direction. The first unit group includes a plurality of first units arranged along a second direction, and the second unit group includes a plurality of second units arranged along the second direction. Each of the first unit and the second unit includes a first sub-pixel, a second sub-pixel, and a third sub-pixel. The shape of at least one of the first sub-pixel, the second sub-pixel, and the third sub-pixel includes an arc edge. In the first unit, the first sub-pixel and the third sub-pixel are arranged along the first direction, and the second sub-pixel is arranged at a side of the first sub-pixel and the third sub-pixel along the second direction. In the second unit, the first sub-pixel and the third sub-pixel are arranged along the first direction, and the second sub-pixel is arranged at another side of the first sub-pixel and the third sub-pixel along the second direction.

## Description

### CROSS-REFERENCE TO RELATED APPLICATION

The present application claims priority to Chinese Patent Application No. 202510238504.5, filed on February 28, 2025, the content of which is incorporated herein by reference in its entirety.

### TECHNICAL FIELD

The present application relates to the technical field of display and, in particular, to a display panel and a display apparatus.

### BACKGROUND

With the continuous development of science and technology, more and more electronic devices with display functions have been widely used in people's daily life and work, resulting in great convenience to people's daily life and work, and becoming an indispensable tool for people today. The main component of electronic devices to realize the display function is the display panel.

To achieve full-color display of the display panel, a plurality of sub-pixels with different light-emitting colors are provided therein, such as red sub-pixels, green sub-pixels and blue sub-pixels. The relevant technicians focus their research on how to arrange the sub-pixels of the display panel to achieve excellent display effect of the display panel.

### SUMMARY

An embodiment of the present application provides a display panel and a display apparatus for improving the display effect of the display panel.

In a first aspect, an embodiment of the present application provides a display panel, including: a substrate; and a plurality of first unit groups and a plurality of second unit groups provided at a same side of the substrate. The plurality of first unit groups and the plurality of second unit groups are alternately arranged in a first direction. At least one of the first unit groups includes a plurality of first units arranged along a second direction. The second direction intersects with the first direction. At least one of the second unit groups includes a plurality of second units arranged along the second direction. Each of the first unit and the second unit includes a first sub-pixel, a second sub-pixel and a third sub-pixel, and a shape of at least one of the first sub-pixel, the second sub-pixel and the third sub-pixel includes an arc edge.

In the first units, the first sub-pixel and the third sub-pixel are arranged along the first direction, and the second sub-pixel is arranged at a side of the first sub-pixel and the third sub-pixel along the second direction.

In the second units, the first sub-pixel and the third sub-pixel are arranged along the first direction, and the second sub-pixel is arranged at another side of the first sub-pixel and the third sub-pixel along the second direction.

In a second aspect, an embodiment of the present application provides a display apparatus including the display panel as described above.

The display panel and the display apparatus according to embodiments of the present application can reduce the risk of diffraction and improve the display effect by setting the shape of at least one of the first sub-pixel, the second sub-pixel and the third sub-pixel to include an arc edge. Moreover, according to embodiments of the present application, in the first unit, the first sub-pixel and the third sub-pixel are arranged along the first direction, and the second sub-pixel is arranged at a side of the first sub-pixel and the third sub-pixel along the second direction; while in the second unit, the first sub-pixel and the third sub-pixel are arranged along the first direction, and the second sub-pixel is arranged at another side of the first sub-pixel and the third sub-pixel along the second direction. As a result, compared with the method of arranging the second sub-pixel of the first unit and the second unit at the same side of the first sub-pixel and the third sub-pixel along the second direction, on the one hand, the arrangement types of pixel units of the display panel can be increased, and on the other hand, the area of the space available for providing each sub-pixel of the first unit and the second unit can be increased, thereby improving the space utilization of the display panel, facilitating increasing the area of each sub-pixel of the first unit and the second unit, and increasing the aperture ratio of the sub-pixel, so as to reduce the current density of the sub-pixel, extend the product life of the display panel, and reduce the power consumption of the display panel.

### BRIEF DESCRIPTION OF DRAWINGS

To clearly illustrate the technical solutions of the embodiments of the present application, the drawings required in the embodiments are briefly introduced below. It is appreciated that the drawings described below are only some embodiments of the present application. For those skilled in the art, other drawings can be obtained according to these drawings without any creative effort.
FIG. 1 is a schematic diagram of a display panel according to some embodiments of the present application;
FIG. 2 is a schematic cross-sectional view of a display panel according to some embodiments of the present application;
FIG. 3 is a schematic diagram of a display panel in the related art;
FIG. 4 is a schematic diagram of a further display panel in the related art;
FIG. 5 is a schematic diagram of a display panel including target evaporation areas of a plurality of sub pixels according to some embodiments of the present application;
FIG. 6 is a schematic diagram of a further display panel including target evaporation areas of a plurality of sub-pixels according to some embodiments of the present application;
FIG. 7 is an enlarged schematic diagram of a third sub-pixel of a fourth sub-unit, a second sub-pixel of a fifth sub-unit, and a second sub-pixel of a sixth sub-unit shown in FIG. 6;
FIG. 8 is a schematic diagram of a further display panel according to some embodiments of the present application;
FIG. 9 is a schematic diagram of a further display panel according to some embodiments of the present application;
FIG. 10 is a schematic diagram of a further display panel according to some embodiments of the present application;
FIG. 11 is a schematic cross-sectional view of a further display panel according to some embodiments of the present application; and
FIG. 12 is a schematic diagram of a display apparatus according to some embodiments of the present application.

### DESCRIPTION OF EMBODIMENTS

To better understand the technical solutions of the present application, embodiments of the present application are described in detail below in conjunction with the drawings.

It should be clarified that the described embodiments are just some, rather than all, of embodiments of the present application. According to embodiments of the present application, all other embodiments obtained by those skilled in the art without any creative effort shall fall within the protection scope of the present application.

The terms used in the embodiments of the present application are only for the purpose of describing specific embodiments and are not intended to limit the present application. The singular forms "a/an", "said" and "the" used in the embodiments of the present application and the claims are intended to include plural forms unless the context clearly indicates otherwise.

It should be understood that the term "and/or" herein is only used to describe the association relationship of associated objects, indicating that three relationships may exist. For example, A and/or B can represent: A exists alone, A and B exist at the same time, and B exists alone. In addition, the character "/" herein generally indicates that the associated objects before and after are in an "or" relationship.

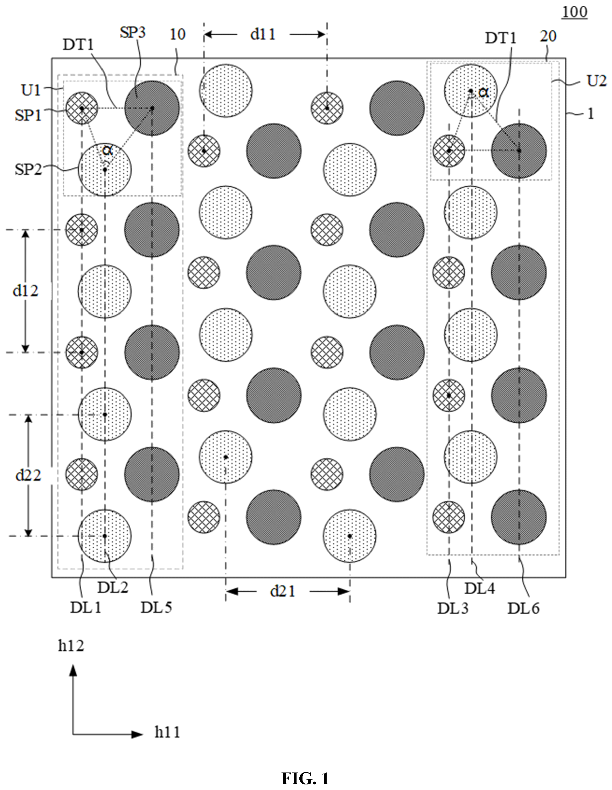

An embodiment of the present application provides a display panel. As shown in FIG. 1, FIG. 1 is a schematic top view of a display panel according to some embodiments of the present application. The display panel 100 includes: a substrate 1; and a plurality of first unit groups 10 and a plurality of second unit groups 20 provided at a same side of the substrate 1. The first unit groups 10 and the second unit groups 20 are alternately arranged in a first direction h11. The first unit group 10 includes a plurality of first units U1 arranged along a second direction h12, and the second direction h12 intersects with the first direction h11. The second unit group 20 includes a plurality of second units U2 arranged along the second direction h12. The first unit U1 and the second unit U2 both include a plurality of sub-pixels. In some embodiments of the present application, the sub-pixels include a first sub-pixel SP1, a second sub-pixel SP2 and a third sub-pixel SP3. In an embodiment, the light-emitting colors of the first sub-pixel SP1, the second sub-pixel SP2 and the third sub-pixel SP3 are different from each other. When the display panel is displaying, the first unit U1 and the second unit U2 can both be used as a pixel unit for display. That is, the first unit U1 and the second unit U2 do not need to borrow sub-pixels of other pixel units for display.

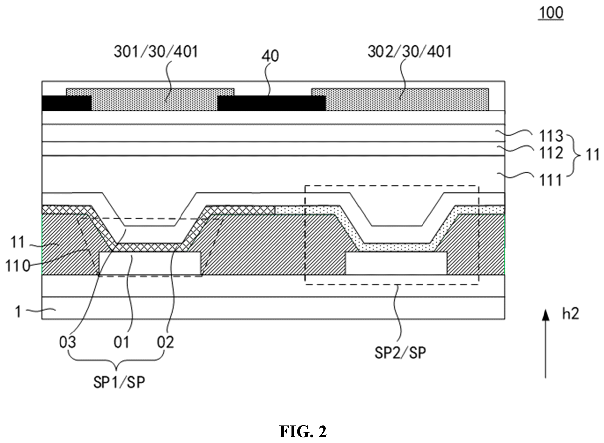

In an embodiment, a shape of at least one of the first sub-pixel SP1, the second sub-pixel SP2 and the third sub-pixel SP3 includes an arc edge. It should be noted that, as shown in FIG. 2, FIG. 2 is a schematic cross-sectional diagram of a display panel according to some embodiments of the present application. The display panel further includes a pixel definition layer (referred to as PDL) 11, and the sub-pixel SP includes a first electrode 01, a light-emitting layer 02 and a second electrode 03 arranged in a stacked manner. The pixel definition layer 11 includes a pixel opening 110, and at least a portion of the light-emitting layer 02 is provided in the pixel opening 110. A shape of the above sub-pixel SP mentioned in the embodiments of the present application can be understood as the shape of an orthographic projection of the pixel opening 110 on the plane of the substrate 1. In an embodiment, the shape of the first sub-pixel SP1 includes an arc edge. That is, the shape of the orthographic projection of the pixel opening 110, of the pixel definition layer 11, used to form the first sub-pixel SP1 on the plane of the substrate 1 includes an arc edge.

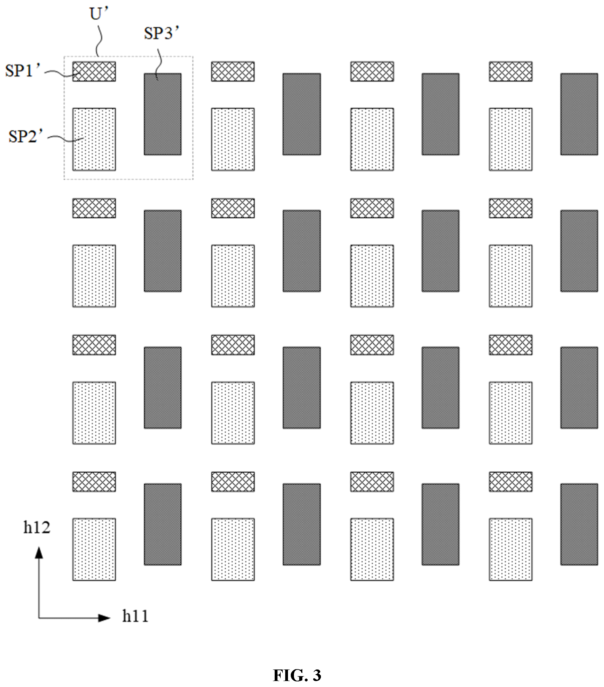

In the related art, the shape of the sub-pixel is usually a quadrilateral or polygonal shape with relatively obvious edges and angles. As shown in FIG. 3, FIG. 3 is a schematic diagram of a display panel in the related art. The pixel unit U' includes a first sub-pixel SP1', a second sub-pixel SP2' and a third sub-pixel SP3', and the shapes of the first sub-pixel SP1', the second sub-pixel SP2' and the third sub-pixel SP3' are all rectangular. To reduce the reflection of ambient light so that the display panel has an integrated black effect, in combination with FIG. 2, a light-shielding layer 40 usually needs to be prepared between adjacent sub-pixels SP. The light-shielding layer 40 is provided at the light-emitting side of the sub-pixel SP, and the shape of the opening of the light-shielding layer 40 follows the shape of the sub-pixel SP. When the light-shielding layer 40 is prepared between adjacent rectangular sub-pixels, the light emitted by the sub-pixels through the opening of the light-shielding layer 40 is equivalent to passing through a slit, which causes a diffraction effect, thereby resulting in a series of light and dark stripes on the light-emitting surface of the display panel, and affecting the display effect of the display panel.

In some embodiments of the present application, the shape of at least one of the first sub-pixel SP1, the second sub-pixel SP2 and the third sub-pixel SP3 includes a circle, and when providing the light-shielding layer 40, the shape of the opening, corresponding to the sub-pixel SP can also be a circle, of the light-shielding layer 40, which can reduce the probability of the diffraction effect when the sub-pixel SP emits light, avoid the appearance of stripes on the surface of the display panel 100, and improve the visual effect of the display panel 100.

In some embodiments of the present application, at least one of the first sub-pixel SP1, the second sub-pixel SP2 and the third sub-pixel SP3 has a circular shape. That is, the shape of the pixel opening 110 corresponding to any one of the three includes a circle. FIG. 1 shows an example that all three sub-pixels are circular. The circular configuration can further weaken the diffraction phenomenon and improve the display effect of the display panel.

It should be noted that, taking into account the process errors, the circular shapes of the first sub-pixel SP1, the second sub-pixel SP2 and the third sub-pixel SP3 can be circles within the allowable range of the process errors. In an embodiment, the actual shapes of the first sub-pixel SP1, the second sub-pixel SP2 and the third sub-pixel SP3 can be quasi-circular shapes that are similar to circles.

In some embodiments of the present application, as shown in FIG. 1, in the first unit U1, the first sub-pixel SP1 and the third sub-pixel SP3 are arranged along the first direction h11, and the second sub-pixel SP2 is provided at one side of the first sub-pixel SP1 and the third sub-pixel SP3 along the second direction h12. In the second unit U2, the first sub-pixel SP1 and the third sub-pixel SP3 are arranged along the first direction h11, and the second sub-pixel SP2 is provided at another side of the first sub-pixel SP1 and the third sub-pixel SP3 along the second direction h12.

Taking the orientation shown in FIG. 1 as an example, in the first unit U1, the second sub-pixel SP2 is provided at the upper side of the first sub-pixel SP1 and the third sub-pixel SP3 along the second direction h12. In the second unit U2, the second sub-pixel SP2 is provided at the lower side of the first sub-pixel SP1 and the third sub-pixel SP3 along the second direction h12.

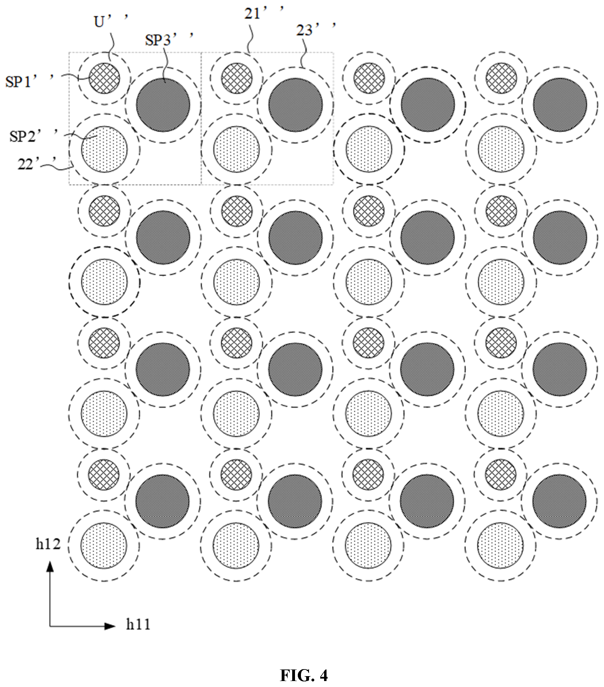

Compared with FIG. 4, FIG. 4 is a schematic diagram of a further display panel in the related ar. The arrangement types of the plurality of pixel units U'' of the display panel are the same. That is, in each pixel unit U'', the second sub-pixel SP2'' is provided at the same side of the first sub-pixel SP1'' and the third sub-pixel SP3'' along the second direction h12 (taking the orientation shown in FIG. 4 as an example, the second sub-pixel SP2'' is provided at the lower side of the first sub-pixel SP1'' and the third sub-pixel SP3'' along the second direction h12). It can be seen that there is a large unused space around the second sub-pixel SP2'', thereby resulting in a low space utilization of the display panel.

In contrast, by adopting the setting method according to some embodiments of the present application, on one hand, the arrangement types of pixel units of the display panel can be increased; and on the other hand, the area of the space available for providing each sub-pixel of the first unit U1 and the second unit U2 can be increased, thereby improving the space utilization of the display panel, facilitating increasing the area of each sub-pixel of the first unit U1 and the second unit U2, and increasing the aperture ratio of the sub-pixel, so as to reduce the current density of the sub-pixel, extend the product life of the display panel, and reduce the power consumption of the display panel.

In an embodiment, the colors of the emitted light of the first sub-pixel SP1, the second sub-pixel SP2 and the third sub-pixel SP3 described above are different from each other. In an embodiment, the first sub-pixel SP1 includes a red sub-pixel emitting red light, the second sub-pixel SP2 includes a green sub-pixel emitting green light, and the third sub-pixel SP3 includes a blue sub-pixel emitting blue light.

In some embodiments of the present application, as shown in FIG. 1, an area of the first sub-pixel SP1 is less than or equal to an area of the second sub-pixel SP2, the area of the first sub-pixel SP1 is less than or equal to an area of the third sub-pixel SP3, and the area of the second sub-pixel SP2 is less than or equal to the area of the third sub-pixel SP3. In an embodiment, the specific areas of the above sub-pixels can be set according to the respective light-emitting efficiencies thereof.

In some embodiments of the present application, in the first unit U1 and the second unit U2, the first sub-pixel SP1 and the third sub-pixel SP3 are arranged as a sub-pixel row along the first direction h11, and the second sub-pixel SP2 forms a separate sub-pixel row, so that combined with the configuration of the areas of the above sub-pixels, the spaces occupied by the two sub-pixel rows in the first direction h11 can be balanced, which is beneficial to further improving the space utilization of the display panel and increasing the aperture ratio of each sub-pixel.

In an embodiment, the area of the first sub-pixel SP1 is S1, and the area of the third sub-pixel SP3 is S3, where 1/6≤S1/S3≤1. In such a setting manner, the areas of the first sub-pixel SP1 and the third sub-pixel SP3 can be matched with the respective light-emitting efficiencies thereof.

In some embodiments, as shown in FIG. 1, in the first unit U1 and the second unit U2 adjacent to each other along the first direction h11, the second sub-pixel SP2 of the first unit U1 and the second sub-pixel SP2 of the second unit U2 do not overlap with each other in the first direction h11. That is, the second sub-pixel SP2 of the first unit U1 and the second sub-pixel SP2 of the second unit U2 are arranged staggered in the first direction h11. In such a setting manner, the second sub-pixel SP2 of the first unit U1 and the second sub-pixel SP2 of the second unit U2 can be dispersedly arranged to avoid the centralized arrangement of the second sub-pixels SP2 with a larger area, which is beneficial to improving the space utilization of the first unit U1 and the second unit U2. In addition, the area of the second sub-pixel SP2 can be set as large as possible to improve the pixel aperture ratio of the second sub-pixel SP2.

In some embodiments, as shown in FIG. 1, regarding the first unit U1 and the second unit U2 adjacent to each other along the first direction h11, the second sub-pixel SP2 of one of them two may at least partially overlap with the first sub-pixel SP1 and the third sub-pixel SP2 of the other one along the first direction h11.

In an embodiment, as shown in FIG. 1, a geometric center of the first sub-pixel SP1, a geometric center of the second sub-pixel SP2, and a geometric center of the third sub-pixel SP3 are located at the positions of the three vertices of a virtual triangle DT1, respectively. The virtual triangle DT1 includes a first vertical angle α, and the geometric center of the second sub-pixel SP2 coincides with the vertex of the first vertical angle α. In some embodiments of the present application, an orientation of the first vertical angle α of the first unit U1 is opposite to an orientation of the first vertical angle α of the second unit U2. FIG. 1 shows that the first vertical angle α of the first unit U1 is facing upward and the first vertical angle α of the second unit U2 is facing downward. Based on this setting method, the second sub-pixels SP2 of the first unit U1 and the second unit U2 can be dispersedly arranged, which is beneficial to balancing the space available for providing each sub-pixel of the first unit U1 and the second unit U2, thereby improving the space utilization of the display panel, and increasing the area of each sub-pixel, so as to increase the aperture ratio of the sub-pixel.

In an embodiment, the shape of the sub-pixel SP in the embodiments of the present application may be a central symmetrical figure or may be an axisymmetric figure with two or more symmetry axes. In an embodiment, an ellipse, a parallelogram (non-rectangular and non-rhombus), a circle, a rounded rectangle, a regular polygon, a rectangle, a rhombus, etc. are all regular figures. For the central symmetrical figure, the central symmetrical point thereof is the geometric center. For the axisymmetric figure with two or more symmetry axes, the intersection of two symmetry axes thereof is the geometric center. In an embodiment, the shape of the sub-pixel in the embodiments of the present application may also be an irregular figure, and the geometric center of the irregular figure may be determined by relevant techniques.

In some embodiments of the present application, as shown in FIG. 2, the display panel 100 further includes an encapsulation layer 11 provided at a side of the sub-pixel SP away from the substrate 1, the light-shielding layer 40 and a color filter (referred to as CF) layer 30. The light-shielding layer 40 may be provided at a side of the encapsulation layer 11 away from the substrate 10. The light-shielding layer 40 includes a first opening 401 corresponding to the pixel opening 110, and the color filter layer 30 is at least partially provided in the first opening 401. In an embodiment, the light-shielding layer 40 includes a black matrix (referred to as BM).

In an embodiment, as shown in FIG. 2, the color filter layer 30 includes a first color filter layer 301, a second color filter layer 302 and a third color filter layer (not shown in FIG. 2). Along the direction h2 perpendicular to the plane of the substrate 1, the first color filter layer 301 at least partially overlaps with the first sub-pixel SP1, the second color filter layer 302 at least partially overlaps with the second sub-pixel SP2, and the third color filter layer at least partially overlaps with the third sub-pixel. The light emitted by the sub-pixel SP is emitted through the corresponding color filter layer 30, which can improve the accuracy of the light-emitting color of the sub-pixel SP. In addition, the color filter layer 30 can also reduce the reflectivity of the display panel 100 by absorbing the incident ambient light. Moreover, in such a setting method, it is equivalent to multiplexing the color filter layer 30 as a polarizer, so that there is no need to provide an extra polarizer on the light-emitting side of the display panel 100, which is beneficial to reducing the thickness of the display panel 100.

In an embodiment, as shown in FIG. 2, the encapsulation layer 11 includes a first inorganic encapsulation layer 111, an organic encapsulation layer 112, and a second inorganic encapsulation layer 113 that are arranged in a stacked manner.

In some embodiments of the present application, as shown in FIG. 1, in the first unit U1 and the second unit U2 adjacent to each other along the first direction h11, the geometric center of the first sub-pixel SP1 and the geometric center of the third sub-pixel SP3 of the first unit U1 are not on collinear with the geometric center of the second sub-pixel SP2 of the second unit U2. In other words, the geometric center of the second sub-pixel SP2 of the second unit U2 is arranged staggered relative to the geometric centers of the first sub-pixel SP1 and the third sub-pixel SP3 of the first unit U1 in the first direction h11.

By adopting this setting method, at least a portion of the second sub-pixel SP2 of the second unit U2 can be provided at a position that does not overlap with the first sub-pixel SP1 and the second sub-pixel SP2 of the first unit U1 along the first direction h11. Therefore, on the basis of ensuring that other sub-pixels are not affected, the area of the second sub-pixel SP2 of the second unit U2 can be set as large as possible, which is beneficial to increasing the pixel aperture ratio of the second sub-pixel SP2 of the second unit U2.

In some embodiments of the present application, as shown in FIG. 1, in the first unit U1 and the second unit U2 adjacent to each other along the first direction h11, the geometric center of the first sub-pixel SP1 and the geometric center of the third sub-pixel SP3 of the second unit U2 are not collinear with the geometric center of the second sub-pixel SP2 of the first unit U1. In other words, the geometric center of the second sub-pixel SP2 of the first unit U1 is arranged staggered relative to the geometric centers of the first sub-pixel SP1 and the third sub-pixel SP3 of the second unit U2 in the first direction h11.

By adopting this setting method, at least a portion of the second sub-pixel SP2 of the first unit U1 can be provided at a position that does not overlap with both the first sub-pixel SP1 and the second sub-pixel SP2 of the second unit U2 along the first direction h11. Therefore, on the basis of ensuring that other sub-pixels are not affected, the area of the second sub-pixel SP2 of the first unit U1 can be set as large as possible, which is beneficial to increasing the pixel aperture ratio of the second sub-pixel SP2 of the first unit U1.

In some embodiments of the present application, the areas of sub-pixels with the same light-emitting color of the first unit U1 and the second unit U2 may be the same. That is, the areas of the first sub-pixel SP1 of the first unit U1 and the first sub-pixel SP1 of the second unit U2 are the same, the areas of the second sub-pixel SP2 of the first unit U1 and the second sub-pixel SP2 of the second unit U2 are the same, and the areas of the third sub-pixel SP3 of the first unit U1 and the third sub-pixel SP3 of the second unit U2 are the same. In some embodiments of the present application, one of the first unit U1 and the second unit U2 can be flipped up and down to become the other.

In some embodiments of the present application, as shown in FIG. 1, in the first unit group 10, the geometric centers of the plurality of first sub-pixels SP1 are located on a first virtual line DL1, the geometric centers of the plurality of second sub-pixels SP2 are located on a second virtual line DL2, and the geometric centers of the plurality of third sub-pixels SP3 are located on a fifth virtual line DL5. The first virtual line DL1 does not intersect with the second virtual line DL2, and the fifth virtual line DL5 does not intersect with the second virtual line DL2.

In an embodiment, as shown in FIG. 1, the first virtual line DL1, the second virtual line DL2, and the fifth virtual line DL5 may all extend along the second direction h12, and the three virtual lines may be arranged staggered with each other.

Based on this setting method, the first sub-pixel SP1 and the second sub-pixel SP2 of the first unit U1 can be at least partially arranged staggered in the second direction h12, and the third sub-pixel SP3 and the second sub-pixel SP2 of the first unit U1 can be at least partially arranged staggered in the second direction h12. In some embodiments of the present application, at least a portion of the second sub-pixel SP2 of the first unit U1 can be set to correspond to the gap position between the first sub-pixel SP1 and the third sub-pixel SP3, so that while avoiding affecting the setting space of the first sub-pixel SP1 or the third sub-pixel SP3, the area of the second sub-pixel SP2 can be set as large as possible to increase the aperture ratio of the second sub-pixel SP2.

And/or, as shown in FIG. 1, in the second unit group 20, the geometric centers of the plurality of first sub-pixels SP1 are located on a third virtual line DL3, the geometric centers of the plurality of second sub-pixels SP2 are located on a fourth virtual line DL4, and the geometric centers of the plurality of third sub-pixels SP3 are located on a sixth virtual line DL6. The third virtual line DL3 does not intersect with the fourth virtual line DL4, and the sixth virtual line DL6 does not intersect with the fourth virtual line DL4.

In an embodiment, as shown in FIG. 1, the third virtual line DL3, the fourth virtual line DL4, and the sixth virtual line DL6 may all extend along the second direction h12, and the three virtual lines may be arranged staggered with each other.

Based on this setting method, the first sub-pixel SP1 and the second sub-pixel SP2 of the second unit U2 can be at least partially arranged staggered in the second direction h12, and the third sub-pixel SP3 and the second sub-pixel SP2 of the second unit U2 can be at least partially arranged staggered in the second direction h12. In some embodiments of the present application, at least a portion of the second sub-pixel SP2 of the second unit U2 can be set to correspond to the gap position between the first sub-pixel SP1 and the third sub-pixel SP3, and while avoiding affecting the setting space of the first sub-pixel SP1 or the third sub-pixel SP3, the area of the second sub-pixel SP2 of the second unit U2 can be set as large as possible to increase the aperture ratio of the second sub-pixel SP2 of the second unit U2.

In an embodiment, as shown in FIG. 1, the distance between the geometric centers of the two first sub-pixels SP1 closest to each other in the first direction h11 is d11. As shown in FIG. 1, one of the two first sub-pixels SP1 closest to each other in the first direction h11 belongs to the first unit U1, and the other belongs to the second unit U2. The distance between the geometric centers of the two adjacent first sub-pixels SP1 in the second direction h12 is d12. The two adjacent first sub-pixels SP1 in the second direction h12 may belong to the two adjacent first units U1, respectively, or may belong to the two adjacent second units U2, respectively. In some embodiments of the present application, d11=d12. Based on this setting method, the first sub-pixels SP1 in different directions can be distributed more uniformly, which is beneficial to improving the consistency of the display effect of the display panel in different directions.

And/or, as shown in FIG. 1, the distance between the geometric centers of the two second sub-pixels SP2 closest to each other in the first direction h11 is d21. In an embodiment, as shown in FIG. 1, one of the two second sub-pixels SP2 closest to each other in the first direction h11 belongs to the first unit U1, and the other belongs to the second unit U2. The distance between the geometric centers of two adjacent second sub-pixels SP2 in the second direction h12 is d22. In an embodiment, as shown in FIG. 1, two adjacent second sub-pixels SP2 in the second direction h12 may belong to the two adjacent first units U1, respectively, or may belong to the two adjacent second units U2, respectively. In some embodiments of the present application, d21=d22. Based on this setting method, the second sub-pixels SP2 in different directions can be distributed more uniformly, which is beneficial to improving the consistency of the display effect of the display panel in different directions.

And/or, as shown in FIG. 1, the distance between the geometric centers of the two third sub-pixels SP3 closest to each other in the first direction h11 is d31. In an embodiment, as shown in FIG. 1, one of the two third sub-pixels SP3 closest to each other in the first direction h11 belongs to the first unit U1, and the other belongs to the second unit U2. The distance between the geometric centers of two adjacent third sub-pixels SP3 in the second direction h12 is d32. In an embodiment, as shown in FIG. 1, two adjacent third sub-pixels SP3 in the second direction h12 may belong to the two adjacent first units U1, respectively, or may belong to the two adjacent second units U2, respectively. In some embodiments of the present application, d31=d32. Based on this setting method, the third sub-pixels SP3 in different directions can be distributed more uniformly, which is beneficial to improving the consistency of the display effect of the display panel in different directions.

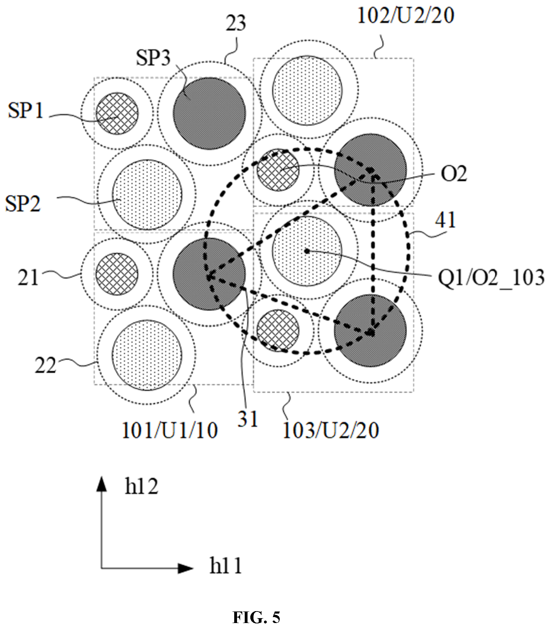

In an embodiment, when preparing the display panel, as shown in FIG. 2, a pixel opening 110 may be first made in a pixel definition layer 11, and then a light-emitting material may be evaporated in the pixel opening 110 through a fine metal mask (referred to as FMM) having an opening to form the light-emitting layer 02. To balance the process capability and improve the product yield, in an embodiment, as shown in FIG. 2, at least a portion of the light-emitting material may also be located outside the pixel opening 110. The area where the light-emitting material is desired to be evaporated during the design process is defined as the target evaporation area. As shown in FIG. 5, FIG. 5 is a schematic diagram of a display panel including target evaporation areas of a plurality of sub-pixels according to some embodiments of the present application. FIG. 5 shows the target evaporation area of the light-emitting material with a dotted line. The display panel includes a first target evaporation area 21 corresponding to the first sub-pixel SP1, a second target evaporation area 22 corresponding to the second sub-pixel SP2, and a third target evaporation area 23 corresponding to the third sub-pixel SP3. As shown in FIG. 5, the area of the target evaporation area is slightly larger than the area of the corresponding sub-pixel. The target evaporation area and the corresponding sub-pixel may be concentric circles.

When the arrangement rules of the plurality of sub-pixels of the first unit U1 and the second unit U2 are set to be the same, as shown in FIG. 4, the second sub-pixel SP2'' and the target evaporation areas corresponding to a plurality of surrounding sub-pixels, such as the third target evaporation area 23'' of another pixel unit U'' adjacent to the pixel unit U'' to which the second sub-pixel SP2'' belongs in the second direction h12, are arranged at intervals, resulting in a large unused space in the display panel and a low space utilization of the display panel.

In some embodiments of the present application, one of the first unit group 10 and the second unit group 20 includes a first sub-unit 101, and the other includes a second sub-unit 102 and a third sub-unit 103. FIG. 5 shows an example in which some of the first units U1 of the first unit group 10 includes the first sub-unit 101, and some of the second units U2 of the second unit group 20 includes the second sub-unit 102 and the third sub-unit 103. In this example, the second sub-unit 102 and the third sub-unit 103 are adjacently arranged in the second direction h12, and the third sub-unit 103 is provided at a side of the first sub-pixel SP1 of the second sub-unit 102 away from the second sub-pixel SP2 (taking the orientation shown in FIG. 5 as an example, the third sub-unit 103 is located below the second sub-unit 102). The first sub-unit 101 and the third sub-unit 103 are adjacently arranged in the first direction h11, and the first sub-unit 101 is provided at a side of the first sub-pixel SP1 of the third sub-unit 103 away from the third sub-pixel SP3 (taking the orientation shown in FIG. 5 as an example, the first sub-unit 101 is provided at the left side of the third sub-unit 103).

As shown in FIG. 5, the lines connecting the geometric centers of the third sub-pixel SP3 of the first sub-unit 101, the third sub-pixel SP3 of the second sub-unit 102 and the third sub-pixel SP3 of the third sub-unit 103 form a first virtual inscribed triangle 31. The first virtual inscribed triangle 31 defines a first virtual circumscribed circle 41.

In some embodiments of the present application, a center Q1 of the first virtual circumscribed circle 41 coincides with a geometric center O2_103 of the second sub-pixel SP2 of the third sub-unit 103. Based on this setting method, a second target evaporation region 22 corresponding to the second sub-pixel SP2 of the third sub-unit 103 can be tangent to a third target evaporation region 23 corresponding to the third sub-pixel SP3 of the first sub-unit 101, a third target evaporation region 23 corresponding to the third sub-pixel SP3 of the second sub-unit 102, and a third target evaporation region 23 corresponding to the third sub-pixel SP3 of the third sub-pixel unit 103, respectively.

For two adjacent sub-pixels, if the target evaporation areas corresponding to the two sub-pixels are arranged at intervals, the interval position causes space waste, affecting the improvement of the PPI of the display panel. If the target evaporation areas corresponding to the two sub-pixels overlap with each other, when process deviation exists, it is easy to cause the light-emitting material corresponding to the sub-pixel to fall into the pixel opening of another adjacent sub-pixel, resulting in display abnormality.

In some embodiments of the present application, the second target evaporation area 22 corresponding to the second sub-pixel SP2 of the third sub-unit 103 tangent to the third target evaporation area 23 corresponding to the third sub-pixel SP3 of the first sub-unit 101, the third target evaporation area 23 corresponding to the third sub-pixel SP3 of the second sub-unit 102, and the third target evaporation area 23 corresponding to the third sub-pixel SP3 of the third sub-pixel unit 103, respectively, so that the display effect can be ensured and the PPI of the display panel can be improved, and meanwhile, at least the areas corresponding to the second sub-pixel SP2 of the third sub-unit 103, the third sub-pixel SP3 of the first sub-unit 101, and the third sub-pixel SP3 of the third sub-pixel unit 103 can be set as large as possible, which is beneficial to improving the aperture ratio of the corresponding sub-pixels.

In some embodiments of the present application, the display panel can include the plurality of first sub-units 101, the plurality of second sub-units 102 and the plurality of third sub-units 103 as mentioned above, so that the second target evaporation areas 22 corresponding to the plurality of second sub-pixels SP2 are tangent to the third target evaporation areas 23 corresponding to the three third sub-pixels SP3 located outside the second sub-pixels SP2, respectively, thereby increasing the pixel aperture ratio of the plurality of second sub-pixels SP2 and the plurality of third sub-pixels SP3.

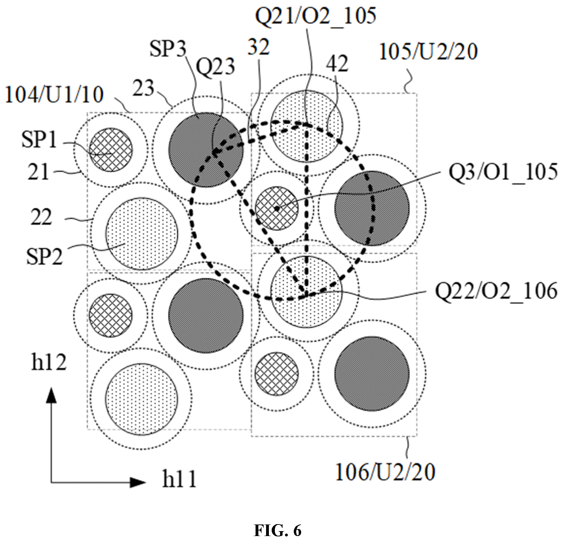

In some embodiments of the present application, as shown in FIG. 6, FIG.6 is a schematic diagram of a further display panel including target evaporation areas of a plurality of sub-pixels according to some embodiment of the present application. One of the first unit group 10 and the second unit group 20 includes a fourth sub-unit 104, and the other includes a fifth sub-unit 105 and a sixth sub-unit 106. FIG. 6 shows an example in which some of the first units U1 of the first unit group 10 includes the fourth sub-unit 104, and some of the second units U2 of the second unit group 20 includes the fifth sub-unit 105 and the sixth sub-unit 106. In this example, the fifth sub-unit 105 and the sixth sub-unit 106 are adjacently arranged in the second direction h12, and the sixth sub-unit 106 is provided at a side of the first sub-pixel SP1 of the fifth sub-unit 105 away from the second sub-pixel SP2 (taking the orientation shown in FIG. 6 as an example, the sixth sub-unit 106 is located below the fifth sub-unit 105). The fourth sub-unit 104 and the fifth sub-unit 105 are adjacently arranged in the first direction h11, and the fourth sub-unit 104 is provided at a side of the first sub-pixel SP1 of the fifth sub-unit 105 away from the second sub-pixel SP2 (taking the orientation shown in FIG. 6 as an example, the fourth sub-unit 104 is located at the left side of the fifth sub-unit 105). As shown in FIG. 6, the display panel includes a second virtual inscribed triangle 32, a first vertex Q21 of the second virtual inscribed triangle 32 coincides with a geometric center O2_105 of the second sub-pixel SP2 of the fifth sub-unit 105, and a second vertex Q22 of the second virtual inscribed triangle 32 coincides with the geometric center O2_106 of the second sub-pixel SP2 of the sixth sub-unit 106. An orthographic projection of the third sub-pixel SP3 of the fourth sub-unit 104 on the plane of the substrate 1 covers a third vertex Q23 of the second virtual inscribed triangle 32.

As shown in FIG. 6, the second virtual inscribed triangle 32 defines a second virtual circumscribed circle 42, and a center Q3 of the second virtual circumscribed circle 42 coincides with a geometric center O1_105 of the first sub-pixel SP1 of the fifth sub-unit 105.

Based on this setting method, the first target evaporation area 21 corresponding to the first sub-pixel SP1 of the fifth sub-unit 105 can be tangent to the third target evaporation area 23 corresponding to the third sub-pixel SP3 of the fourth sub-unit 104, the second target evaporation area 22 corresponding to the second sub-pixel SP2 of the fifth sub-unit 105, and the second target evaporation area 22 corresponding to the second sub-pixel SP2 of the sixth sub-unit 106, respectively. As a result, the target evaporation areas corresponding to two adjacent sub-pixels can be prevented from overlapping or being spaced a certain distance apart. While taking into account both improving the PPI of the display panel and reducing the process difficulty of the display panel, the areas of the first sub-pixel of in the fifth sub-unit 105, the third sub-pixel SP3 of the fourth sub-unit 104, the second sub-pixel SP2 of the fifth sub-unit 105, and the second sub-pixel SP2 of the sixth sub-unit 106 can be increased, which is beneficial to improving the aperture ratio of the plurality of sub-pixels.

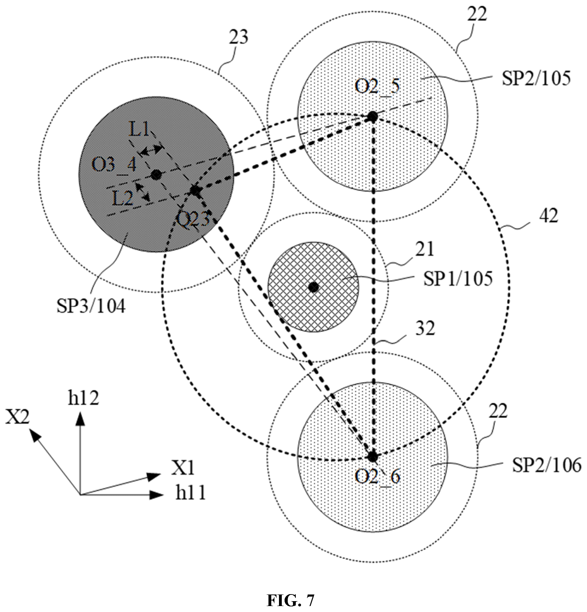

In some embodiments of the present application, as shown in FIG. 7, FIG. 7 is an enlarged schematic diagram of the third sub-pixel SP3 of the fourth sub-unit 104, the first sub-pixel SP1 and the second sub-pixel SP2 of the fifth sub-unit 105, and the second sub-pixel SP2 of the sixth sub-unit 106 shown in FIG. 6. Along a first preset direction X1, the distance between the third vertex Q23 of the second virtual inscribed triangle 32 and a geometric center O3_4 of the third sub-pixel SP3 of the fourth sub-unit 104 is L1, and the first preset direction X1 is parallel to the line connecting the geometric center O3_4 of the third sub-pixel SP3 of the fourth sub-unit 104 and a geometric center O2_5 of the second sub-pixel SP2 of the fifth sub-unit 105. Along a second preset direction X2, the distance between a third vertex Q23 of the second virtual inscribed triangle 32 and the geometric center O3_4 of the third sub-pixel SP3 of the fourth sub-unit is L2, and the second preset direction X2 is parallel to the line connecting the geometric center O3_4 of the third sub-pixel SP3 of the fourth sub-unit 104 and a geometric center O2_6 of the second sub-pixel SP2 of the sixth sub-unit 106. In an embodiment of the present application, L1=L2.

In an embodiment, L1=L2=r₂₃-r₂₂, where r₂₃ is the radius of the third target evaporation area 23, and r₂₂ is the radius of the second target evaporation area 22.

Based on this setting method, as shown in FIG. 7, the third target evaporation area 23 corresponding to the third sub-pixel SP3 of the fourth sub-unit 104 can be tangent to the second target evaporation area 22 corresponding to the second sub-pixel SP2 of the fifth sub-unit 105, which is beneficial to increasing the areas of the third sub-pixel SP3 of the fourth sub-unit 104 and the second sub-pixel SP2 of the fifth sub-unit 105, improving the aperture ratio of them two, and improving the space utilization of the display panel.

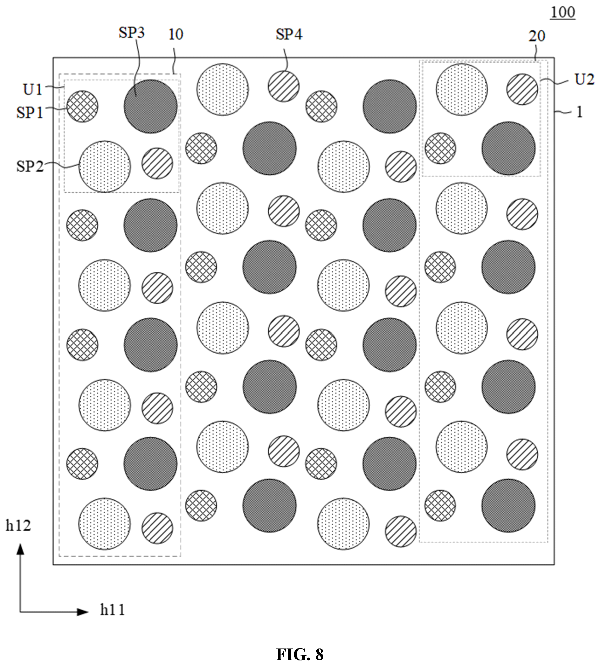

In some embodiments of the present application, at least one first unit U1 and/or at least one second unit U2 may further include a fourth sub-pixel, as shown in FIG. 8. FIG. 8 is a schematic diagram of a further display panel according to some embodiments of the present application, and shows that both the plurality of first units U1 and the plurality of second units U2 include a fourth sub-pixel SP4. The fourth sub-pixel SP4 and the second sub-pixel SP2 are arranged along the first direction h11, and the fourth sub-pixel SP4 and the third sub-pixel SP3 are arranged along the second direction h12. The arrangement of the fourth sub-pixel SP4 can improve the display effect of the display panel. Moreover, in some embodiments of the present application, the fourth sub-pixel SP4 is arranged along the first direction h11 with the second sub-pixel SP2 and along the second direction h12 with the third sub-pixel SP3, which is beneficial to further improving the space utilization of the display panel.

In some embodiments of the present application, as shown in FIG. 8, the area of the fourth sub-pixel SP4 is less than or equal to the area of at least one of the first sub-pixel SP1, the second sub-pixel SP2, and the third sub-pixel SP3.

In some embodiments of the present application, the fourth sub-pixel SP4 includes a white sub-pixel. The white sub-pixel can emit white light. The arrangement of the white sub-pixel is beneficial to reducing the power consumption of the display panel and improving the brightness of the display panel.

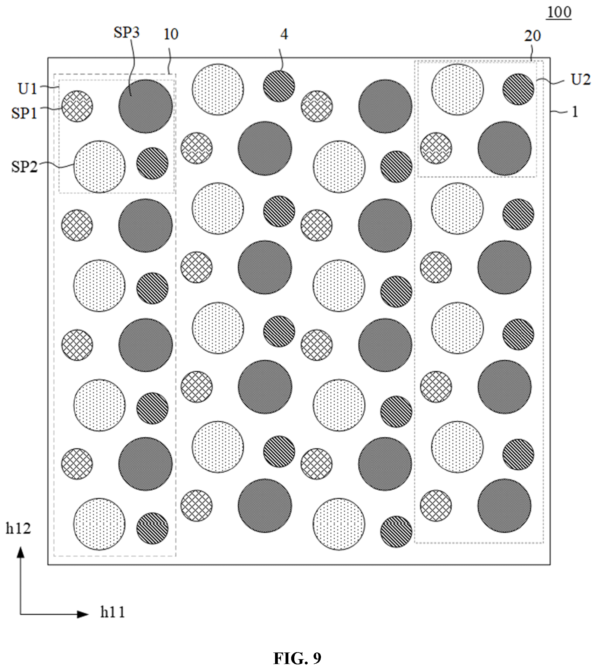

In an embodiment, as shown in FIG. 9, FIG. 9 is a schematic diagram of a further display panel according to some embodiments of the present application. At least one first unit U1 and/or at least one second unit U2 further include a support portion 4. FIG. 9 shows an example in which both the plurality of first units U1 and the plurality of second units U2 include the support portion. The support portion 4 can be configured to support the fine metal mask used in the preparation process of the display panel 100. Moreover, in some embodiments of the present application, the support portion 4 is arranged along the first direction h11 with the second sub-pixel SP2 and along the second direction h12 with the third sub-pixel SP3, which is beneficial to further improving the space utilization of the display panel.

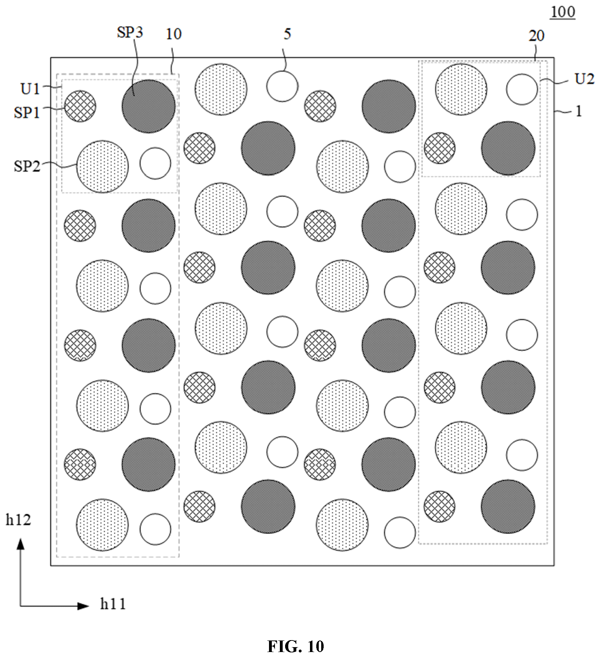

In an embodiment, as shown in FIG. 10, FIG. 10 is a schematic diagram of a further display panel according to some embodiments of the present application. At least one first unit U1 and/or at least one second unit U2 further includes a light-transmitting area 5. FIG. 10 shows an example in which the plurality of first units U1 and the plurality of second units U2 both include the light-transmitting area 5. The light-transmitting area 5 and the second sub-pixel SP2 are arranged along the first direction h11, and the light-transmitting area 5 and the third sub-pixel SP3 are arranged along the second direction h12.

In some embodiments of the present application, the light transmittance of the light-transmitting area 5 is greater than or equal to the light transmittance of other areas of the display panel. The arrangement of the light-transmitting area 5 can improve the light transmittance of the display panel. In an embodiment, the display panel can be used in conjunction with a light sensor, and during the operation of the light sensor, ambient light can enter the light sensor through the light-transmitting area 5. The light sensor can perform operations such as adjusting the brightness of the display panel in response to the intensity of the collected ambient light. Moreover, in some embodiments of the present application, the light-transmitting area 5 is arranged along the first direction h11 with the second sub-pixel SP2 and along the second direction h12 with the third sub-pixel SP3, which is beneficial to further improving the space utilization of the display panel.

In some embodiments of the present application, the above light sensors include camera modules, distance sensors, iris recognition sensors, infrared sensors, etc., but are not limited thereto.

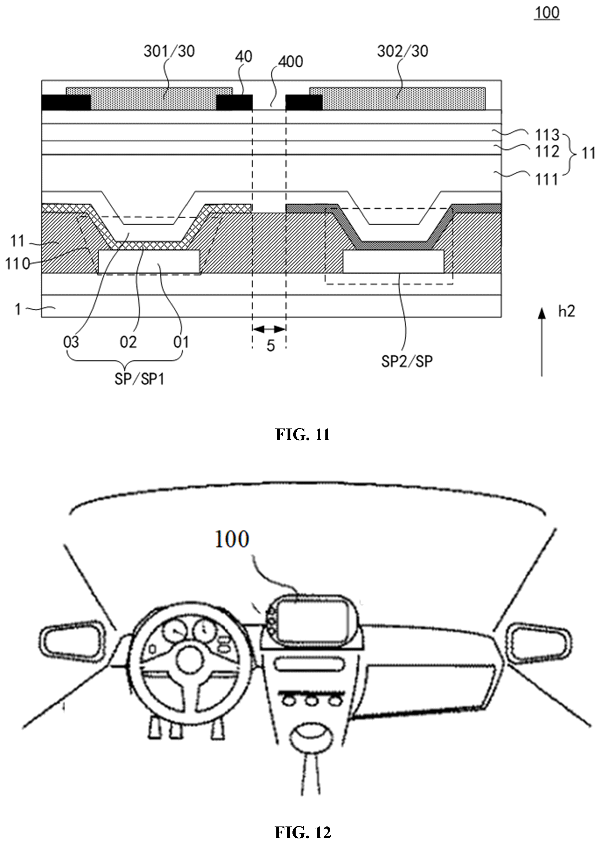

In an embodiment, as shown in FIG. 11, FIG. 11 is a schematic cross-sectional view of a further display panel according to some embodiments of the present application. The display panel further including a light-shielding layer 40 provided at a side of the sub-pixel SP away from the substrate 1. The light-shielding layer 40 includes an opening 400, and an orthographic projection of the opening 400 on the plane of the substrate 1 at least partially overlaps with the light-transmitting area 5. The arrangement of the opening 400 can improve the light transmittance of the light-shielding layer 40 at the location of the light-transmitting area 5.

In some embodiments of the present application, as shown in FIG. 11, the light-emitting layer 02 is provided away from the light-transmitting area 5 to further increase the light transmittance of the light-transmitting area 5.

Based on the same inventive concept, an embodiment of the present application further provides a display apparatus, as shown in FIG. 12. FIG. 12 is a schematic diagram of a display apparatus according to some embodiments of the present application, and the display apparatus includes the display panel described above. The specific structure of the display panel 100 has been described in detail in the above embodiments, which will not be elaborated herein. The display apparatus shown in FIG. 12 is just for schematic illustration. The display apparatus can be any apparatus with a display function, such as a mobile phone, a tablet computer, a laptop computer, a car display screen, an e-book, a television, a smart watch, which are not limited thereto in the embodiments of the present application.

The above description is merely preferred embodiments of the present application, and is not intended to limit the present application. Any modification, equivalent substitution, improvement, etc. made within the spirit and principle of the present application shall fall within the protection scope of the present application.

It should be noted that the above embodiments are merely used to illustrate the technical solutions of the present application, rather than to limit it. Although the present application has been described in detail with reference to the above embodiments, those skilled in the art should understand that they can still modify the technical solutions described in the above embodiments, or replace some of or all the technical features therein by equivalents. However, these modifications or replacements do not make the essence of the corresponding technical solutions deviate from the scope of the technical solutions of the embodiments of the present application.

## Claims

1. A display panel, comprising:
a substrate; and
a plurality of first unit groups and a plurality of second unit groups provided at a same side of the substrate, wherein the plurality of first unit groups and the plurality of second unit groups are alternately arranged in a first direction, at least one first unit group of the first unit groups comprises a plurality of first units arranged along a second direction intersecting with the first direction, and at least one second unit group of the second unit groups comprises a plurality of second units arranged along the second direction;
wherein each of at least one of the plurality of first units and at least one of the plurality of second units comprises a plurality of sub-pixels, the plurality of sub-pixels comprise a first sub-pixel, a second sub-pixel and a third sub-pixel, and a shape of at least one of the first sub-pixel, the second sub-pixel or the third sub-pixel comprises an arc edge;
wherein in the at least one of the plurality of first units, the first sub-pixel and the third sub-pixel are arranged along the first direction, and the second sub-pixel is arranged at a side of the first sub-pixel and the third sub-pixel along the second direction; and
wherein in the at least one of the plurality of second units, the first sub-pixel and the third sub-pixel are arranged along the first direction, and the second sub-pixel is arranged at another side of the first sub-pixel and the third sub-pixel along the second direction.

2. The display panel of claim 1, wherein
in a first unit and a second unit adjacent to each other along the first direction, a second sub-pixel of the first unit and a second sub-pixel of the second unit do not overlap with each other.

3. The display panel of claim 1, wherein
a geometric center of the first sub-pixel, a geometric center of the second sub-pixel, and a geometric center of the third sub-pixel are located at positions of three vertices of a virtual triangle, respectively, the virtual triangle comprising a first vertical angle, and the geometric center of the second sub-pixel coinciding with a vertex of the first vertical angle; and
an orientation of the first vertical angle of the first unit is opposite to an orientation of the first vertical angle of the second unit.

4. The display panel of claim 1, wherein
the shape of at least one of the first sub-pixel, the second sub-pixel or the third sub-pixel comprises a circle.

5. The display panel of claim 1, further comprising a plurality of color filter layers provided at a side of the sub-pixels away from the substrate, wherein
the plurality of color filter layers comprise a first color filter layer, a second color filter layer and a third color filter layer; and
along a direction perpendicular to a plane of the substrate, the first color filter layer at least partially overlaps with the first sub-pixel, the second color filter layer at least partially overlaps with the second sub-pixel, and the third color filter layer at least partially overlaps with the third sub-pixel.

6. The display panel of claim 1, wherein
in a first unit and a second unit adjacent to each other along the first direction, a geometric center of the first sub-pixel and a geometric center of the third sub-pixel of the first unit are not collinear with a geometric center of the second sub-pixel of the second unit.

7. The display panel of claim 1, wherein
in at least one first unit group of the first unit groups, geometric centers of a plurality of first sub-pixels are located on a first virtual line, geometric centers of a plurality of second sub-pixels are located on a second virtual line, and the first virtual line and the second virtual line do not overlap with each other; and/or
in at least one first unit group of the second unit groups, geometric centers of a plurality of first sub-pixels are located on a third virtual line, geometric centers of a plurality of second sub-pixels are located on a fourth virtual line, and the third virtual line and the fourth virtual line do not overlap with each other.

8. The display panel of claim 1, wherein
a distance between geometric centers of two first sub-pixels closest to each other in the first direction is d11, and a distance between geometric centers of two adjacent first sub-pixels in the second direction is d12;
a distance between geometric centers of two second sub-pixels closest to each other in the first direction is d21, and a distance between geometric centers of two adjacent second sub-pixels in the second direction is d22; and
a distance between geometric centers of two third sub-pixels closest to each other in the first direction is d31, and a distance between geometric centers of two adjacent third sub-pixels in the second direction is d32, and
wherein d11=d12; or d21=d22; or d31=d32.

9. The display panel of claim 1, wherein
one unit group of the first unit group and the second unit group comprises a first sub-unit, and the other unit group of the first unit group and the second unit group comprises a second sub-unit and a third sub-unit;
the second sub-unit and the third sub-unit are arranged adjacent to each other in the second direction and the third sub-unit is located at a side of the first sub-pixel of the second sub-unit away from the second sub-pixel, and the first sub-unit and the third sub-unit are arranged adjacent to each other in the first direction and the first sub-unit is located at a side of the first sub-pixel of the third sub-unit away from the third sub-pixel;
lines connecting a geometric center of the third sub-pixel of the first sub-unit, a geometric center of the third sub-pixel of the second sub-unit and a geometric center of the third sub-pixel of the third sub-unit form a first virtual inscribed triangle; and
the first virtual inscribed triangle defines a first virtual circumscribed circle, and a circle center of the first virtual circumscribed circle coincides with a geometric center of the second sub-pixel of the third sub-unit.

10. The display panel of claim 1, wherein
one unit group of the first unit group and the second unit group comprises a fourth sub-unit, and the other unit group of the first unit group and the second unit group comprises a fifth sub-unit and a sixth sub-unit;
the fifth sub-unit and the sixth sub-unit are arranged adjacent to each other in the second direction and the sixth sub-unit is located at a side of the first sub-pixel of the fifth sub-unit away from the second sub-pixel, and the fourth sub-unit and the fifth sub-unit are arranged adjacent to each other in the first direction and the fourth sub-unit is located at a side of the first sub-pixel of the fifth sub-unit away from the second sub-pixel;
the display panel further comprises a second virtual inscribed triangle, and a first vertex of the second virtual inscribed triangle coincides with a geometric center of the second sub-pixel of the fifth sub-unit, a second vertex of the second virtual inscribed triangle coincides with a geometric center of the second sub-pixel of the sixth sub-unit, and an orthographic projection of the third sub-pixel of the fourth sub-unit on the plane of the substrate covers a third vertex of the second virtual inscribed triangle; and
the second virtual inscribed triangle defines a second virtual circumscribed circle, and a circle center of the second virtual circumscribed circle coincides with a geometric center of the first sub-pixel of the fifth sub-unit.

11. The display panel of claim 10, wherein
along a first preset direction, a distance between the third vertex of the second virtual inscribed triangle and a geometric center of the third sub-pixel of the fourth sub-unit is L1, and the first preset direction is parallel to a line connecting the geometric center of the third sub-pixel of the fourth sub-unit and a geometric center of the second sub-pixel of the fifth sub-unit;
along a second preset direction, a distance between the third vertex of the second virtual inscribed triangle and the geometric center of the third sub-pixel of the fourth sub-unit is L2, and the second preset direction is parallel to a line connecting the geometric center of the third sub-pixel of the fourth sub-unit and a geometric center of the second sub-pixel of the sixth sub-unit; and $L 1 = L 2 .$

12. The display panel of claim 1, wherein at least one of the first units further comprises a fourth sub-pixel, the fourth sub-pixel and the second sub-pixel are arranged along the first direction, and the fourth sub-pixel and the third sub-pixel are arranged along the second direction.

13. The display panel of claim 12, wherein an area of the fourth sub-pixel is less than or equal to an area of at least one of the first sub-pixel, the second sub-pixel, or the third sub-pixel.

14. The display panel of claim 12, wherein the fourth sub-pixel comprises a white sub-pixel.

15. The display panel of claim 1, wherein at least one of the first units further comprises a support portion, the support portion and the second sub-pixel being arranged along the first direction, and the support portion and the third sub-pixel being arranged along the second direction.

16. The display panel of claim 1, wherein at least one of the first units further comprises a light-transmitting area, the light-transmitting area and the second sub-pixel being arranged along the first direction, and the light-transmitting area and the third sub-pixel being arranged along the second direction.

17. The display panel of claim 16, further comprising a light-shielding layer provided at a side of the plurality of sub-pixels away from the substrate, wherein the light-shielding layer is provided with an opening, and an orthographic projection of the opening on a plane of the substrate at least partially overlaps with the light-transmitting area.

18. The display panel of claim 1, wherein the first sub-pixel comprises a red sub-pixel, the second sub-pixel comprises a green sub-pixel, and the third sub-pixel comprises a blue sub-pixel.

19. The display panel of claim 1, wherein an area of the first sub-pixel is less than or equal to an area of the second sub-pixel, the area of the first sub-pixel is less than or equal to an area of the third sub-pixel, and the area of the second sub-pixel is less than or equal to the area of the third sub-pixel.

20. The display panel of claim 19, wherein the area of the first sub-pixel is S1, and the area of the third sub-pixel is S3, and 1/6≤S1/S3≤1.

21. A display apparatus, comprising the display panel of any of claims 1 to 20.
